# EUROPÄISCHE PATENTSCHRIFT

(11) **EP 1 206 707 B1**
(45) Veröffentlichungstag und Bekanntmachung des Hinweises auf die Patenterteilung: **19.02.2003**
(21) Anmeldenummer: 00962460.2
(22) Anmeldetag: 08.09.2000
(51) Int. Cl.: G01R 33/07

(54) **HALL-SENSORANORDNUNG ZUR OFFSET-KOMPENSIERTEN MAGNETFELDMESSUNG**
HALL SENSOR ARRAY FOR MEASURING A MAGNETIC FIELD WITH OFFSET COMPENSATION
DISPOSITIF DE CAPTEURS DE HALL POUR LA MESURE DU CHAMP MAGNETIQUE AVEC COMPENSATION DU DECALAGE

(30) Priorität: 09.09.1999 DE 19943128
(43) Veröffentlichungstag der Anmeldung: 22.05.2002
(73) Patentinhaber: FRAUNHOFER-GESELLSCHAFT ZUR FÖRDERUNG DER ANGEWANDTEN FORSCHUNG E.V., 80636 München (DE)
(72) Erfinder: HOHE, Hans-Peter, 91332 Heiligenstadt (DE); WEBER, Norbert, 91367 Weissenohe (DE); SAUERER, Josef, 91074 Herzogenaurach (DE)
(74) Vertreter: Schoppe, Fritz, Dipl.-Ing.
(86) Internationale Anmeldenummer: EP0008805
(87) Internationale Veröffentlichungsnummer: WO01018556

(56) Entgegenhaltungen:
- EP-A- 0 548 391
- DE-A- 4 302 342
- US-A- 4 668 914
- US-A- 5 747 995

## Beschreibung

Die vorliegende Erfindung bezieht sich im allgemeinen auf Hall-Sensoren und insbesondere die Anordnung und Ansteuerung mehrerer Hall-Sensorelemente in einer Hall-Sensoranordnung zur Offset-kompensierten Magnetfeldmessung.

Ein einzelnes Hall-Sensorelement ist im allgemeinen aus einem n-dotierten aktiven Halbleiterbereich auf einem p-dotierten Halbleitersubstrat aufgebaut. Der n-dotierte aktive Bereich ist üblicherweise über vier Kontaktelektroden bzw. Kontaktanschlüsse, die diagonal gegenüberliegend in dem aktiven Bereich angeordnet sind, mit einer externen Ansteuerlogik verbunden. Die vier Kontaktelektroden des Hall-Sensorelements unterteilen sich in zwei gegenüberliegende Steuerstromkontaktelektroden, die vorgesehen sind, um einen Stromfluß durch den aktiven Bereich zu erzeugen, und ferner in zwei gegenüberliegende Spannungsabgriffkontaktelektroden, die vorgesehen sind, um eine Hall-Spannung, die bei einem anliegenden Magnetfeld senkrecht zu dem Stromfluß in dem aktiven Bereich auftritt, als Sensorsignal abzugreifen.

Aus der Europäischen Patentschrift EP-0548391 B1 ist eine Hall-Sensoranordnung nach dem Oberbegriff des Anspruchs 1 bekannt, bei der zwei oder vier Hall-Sensorelemente zur Kompensation des Störeinflusses einer bestimmten Kristallrichtung verwendet werden. Die einzelnen Hall-Sensorelemente sind um einen bestimmten Winkel zueinander gedreht, der zwischen 0° und 180° liegt. Der Winkel ist dabei entsprechend der Kristallrichtung des verwendeten Halbleitermaterials gewählt. Gemäß der EP-0548391 wird jedes Hall-Element mit einer separaten Stromquelle gespeist, so daß jeweils ein konstanter Strom in jedes Element eingeprägt wird. Die an den einzelnen Hall-Elementen im Halldetektor abgegriffenen Hall-Spannungen werden in einer Schalterstufe parallelgeschaltet. Somit werden die Hallspannungen der einzelnen Elemente auf einen identischen Wert gezwungen, so daß Ausgleichsströme auftreten können.

Bekanntermaßen treten bei den Herstellungsprozessen von Halbleiterstrukturen produktionsbedingt häufig Inhomogenitäten oder Störungen in dem Halbleitermaterial des aktiven Bereichs auf. Diese Inhomogenitäten lassen sich auch mit aufwendigen Herstellungsverfahren nicht vollständig vermeiden. Diese Inhomogenitäten sind häufig ein Grund für das Auftreten eines Offsets des Sensorsignals. Das heißt, an den Kontaktelektroden, an denen die Hall-Spannung abgegriffen wird, wird auch dann ein Sensorsignal erfaßt, wenn kein Magnetfeld an dem aktiven Bereich anliegt. Dieses störende Sensorsignal wird als der Offset des Sensornutzsignals oder einfach auch als Offset-Signal bezeichnet. Durch die starke Abhängigkeit des Offset-Signals von den Inhomogenitäten treten bei herkömmlichen Hall-Sensorelementen große Exemplarstreuungen auf. Ferner wird die Empfindlichkeit und die Meßgenauigkeit der Hall-Sensoren stark beeinträchtigt. Aus diesem Grund ist eine Offset-Kompensation und eine korrekte Auswertung der Sensorsignale im allgemeinen mit einem großen schaltungstechnischen Aufwand verbunden.

Eine weitere Problematik bei Hall-Sensoranordnungen stellen die sogenannten Piezoeffekte dar, die stark von der Kristallrichtung des verwendeten Halbleitermaterials abhängig sind. Die Piezoeffekte können durch mechanische Verspannungen, die aufgrund äußerer Kräfte (z.B. durch das Gehäuse) hervorgerufen werden, oder durch mechanische Spannungen im Kristallgefüge des Halbleitermaterials ein beträchtliches Offset-Signal hervorrufen. Man hat versucht, diese Problematik zu überwinden, indem entweder die Hall-Sensoranordnung an die Kristallrichtung des Halbleitermaterials angepaßt wurde oder indem die Piezoeffekte durch eine geeignete Wahl der Stromrichtungen im Halbleitermaterial in Abhängigkeit von der Kristallrichtung kompensiert wurden. Diese Maßnahmen haben jedoch zur Folge, daß die Herstellungsprozesse dieser Hall-Sensoranordnungen sehr aufwendig sind, da sowohl die Kristallausrichtung der Halbleiteroberfläche als auch die Ausrichtung der Hall-Sensorelemente zueinander und bezügliche der Kristallorientierung beachtet werden müssen.

Ausgehend von diesem Stand der Technik besteht die Aufgabe der vorliegenden Erfindung darin, eine verbesserte und weniger aufwendig herstellbare Hall-Sensoranordnung zu schaffen.

Diese Aufgabe wird durch eine Hall-Sensoranordnung gemäß Anspruch 1 gelöst.

Der vorliegenden Erfindung liegt die Erkenntnis zugrunde, daß der in einer Hall-Sensoranordnung auftretende Offset-Anteil des Sensorsignals durch die oben ausgeführte geometrische Anordnung der einzelnen Hall-Sensorelemente der Paare und der Verschaltung der Anschlüsse stark verringert und somit bereits ein vorkompensiertes Offset-Signal geliefert werden kann. Durch die erfindungsgemäße Anordnung und Verschaltung der Hall-Sensorelemente kann eine Unabhängigkeit der erfaßten Hall-Spannung von der Kristallrichtung des Halbleitermaterials erreicht werden.

Erfindungsgemäß werden die Hall-Sensorelemente im sogenannten "Spinning-Current"-Betrieb angesteuert. Der Spinning-Current-Betrieb besteht darin, daß die Meßrichtung ständig mit einer bestimmten Taktfrequenz um beispielsweise 90° zyklisch weitergedreht wird, d.h. der Betriebsstrom fließt von einer zu der gegenüberliegenden Kontaktelektrode, wobei die Hall-Spannung an den quer dazu liegenden Kontaktelektroden abgegriffen wird, woraufhin dann beim nächsten Zyklus, d.h. der nächsten Meßphase, die Meßrichtung um 90° weitergedreht wird. Die in den einzelnen Meßphasen gemessenen Hall-Spannungen werden durch eine geeignete, vorzeichenrichtige und gewichtete Summierung oder Subtraktion ausgewertet, wobei der in der einzelnen Meßphase noch enthaltene Offset weiter reduziert werden kann bzw. sich die Offset-Spannungen bei einem Umlauf annähernd gegenseitig aufheben sollen, so daß die echt magnetfeldabhängigen Anteile des Hall-Signals übrig bleiben.

Aufgrund der erfindungsgemäßen Orientierung und Verschaltung der Hall-Sensorelemente ist es somit nicht mehr notwendig, die Kristallrichtung des Halbleitermaterials zu berücksichtigen, wodurch der Einfluß der von der Kristallrichtung des Halbleitermaterials abhängigen Piezoeffekte auf die erfaßte Hall-Spannung im wesentlichen vollständig beseitigt werden kann.

Da die starke Abhängigkeit des Offset-Signals sowohl von der Kristallrichtung des Halbleitermaterials als auch von den Inhomogenitäten oder Störungen im Halbleitermaterial durch die erfindungsgemäße Hall-Sensoranordnung im wesentlichen beseitigt ist, wird eine beträchtliche Erhöhung der Empfindlichkeit und der Meßgenauigkeit durch diese Hall-Sensoranordnung erreicht. Aus diesem Grund kann der schaltungstechnische Aufwand, der für eine korrekte Auswertung und Weiterverarbeitung der Sensorsignale erforderlich ist, bei der Hall-Sensoranordnung der vorliegenden Erfindung niedrig gehalten werden.

Aufgrund der verbesserten Empfindlichkeit und Meßgenauigkeit entsprechend dem niedrigeren Offset-Anteil des Sensorsignals der Hall-Sensoranordnung erhöht sich ferner die nutzbare Auflösung der erfaßten Hall-Spannung.

Ein weiterer Vorteil der vorliegenden Erfindung besteht darin, daß der Schaltungsaufwand der Hall-Sensoranordnung weiter verringert werden kann, da durch die untereinander feste Verschaltung der Hall-Sensorelemente eine gemeinsame Betriebsstromeinprägung in alle Hall-Sensorelemente und ein gemeinsamer Abgriff aller Hall-Signale der Hall-Sensorelemente verwendet werden kann. Dadurch wird vermieden, daß sowohl die Betriebsströme in jedes Sensorelement einzeln eingespeist als auch die Hall-Spannungen jedes Sensorelements getrennt erfaßt werden müssen. Dadurch lassen sich zusätzliche Schaltungskomponenten, z.B. zusätzliche Schalter, Stromquellen, Zuleitungen usw., vermeiden. Ferner kann die Komplexität der Auswerteschaltung niedrig gehalten werden.

Bevorzugte Ausführungsbeispiele der vorliegenden Erfindung werden nachfolgend unter Bezugnahme auf die beiliegenden Zeichnungen näher erläutert. Es zeigen:
- Fig. 1:: eine prinzipielle Darstellung einer Hall-Sensoranordnung mit vier Hall-Sensorelementen gemäß der vorliegenden Erfindung;
- Fig. 2 a-c:: prinzipielle Darstellungen weiterer alternativer geometrischer Ausführungen und Anordnungen der Hall-Sensorelemente gemäß der vorliegenden Erfindung; und
- Fig. 3 a-b:: prinzipielle Darstellungen weiterer alternativer geometrischer Anordnungen der Hall-Sensorelemente gemäß der vorliegenden Erfindung.

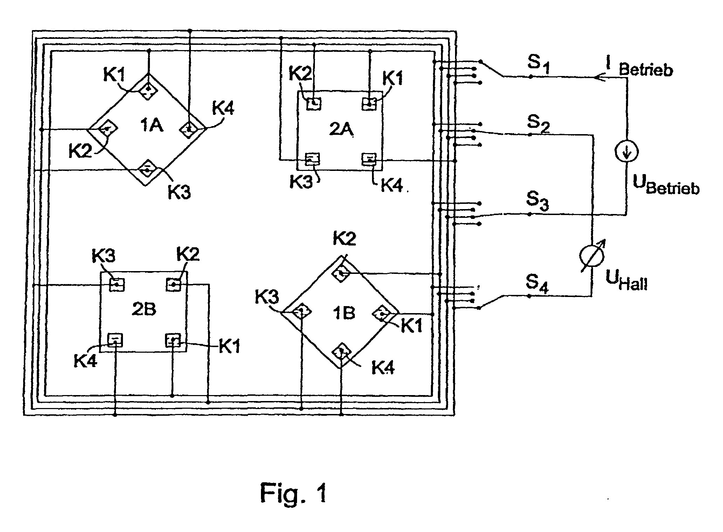

Bezugnehmend auf Fig. 1 wird nun im folgenden der allgemeine Aufbau einer Hall-Sensoranordnung mit zwei Paaren von Hall-Sensorelementen dargestellt.

Auf einem Halbleitersubstrat, das vorzugsweise p-dotiert ist, sind vorzugsweise vier rechteckige, aktive Halbleiterbereiche aufgebracht, die im allgemeinen n-dotiert sind. Vorzugsweise in den Ecken der n-dotierten aktiven Bereiche sind Kontaktelektroden K1, K2, K3, K4 angeordnet, die im allgemeinen durch eine n⁺-Dotierung erhalten werden. Die Kontaktelektroden K1, K2, K3, K4 sind in dem n-dotierten aktiven Bereich jeweils diagonal gegenüberliegend angeordnet, wobei zwei Kontaktelektroden K1, K3 zur Betriebsstromzuführung und die anderen beiden Kontaktelektroden K2, K4 zum Hall-Spannungsabgriff vorgesehen sind. Die aktiven Bereiche bilden die einzelnen Hall-Sensorelemente 1A, 2A, 1B, 2B, wobei bei der in Fig. 1 dargestellten Hall-Sensoranordnung mit vier Hall-Sensorelementen jeweils die Hall-Sensorelemente 1A, 1B und die Hall-Sensorelemente 2A, 2B ein Hall-Sensorelementepaar bilden.

In Fig. 1 zeigt ein Ausführungsbeispiel, bei dem die zwei Hall-Sensorelementepaare in einem Viereck plaziert sind, wobei die einzelnen Paare der Hall-Sensorelemente jeweils diagonal angeordnet sind. Es ist jedoch auch möglich, die beiden Hall-Sensorelemente eines Paars in der Hall-Sensoranordnung untereinander oder auch nebeneinander zu plazieren.

Bei einem bevorzugten Ausführungsbeispiel der erfindungsgemäßen Hall-Sensoranordnung sind jeweils die Kontaktelektroden K1, die Kontaktelektroden K2, die Kontaktelektroden K3 und die Kontaktelektroden K4 der einzelnen Hall-Sensorelemente 1A, 2A, 1B, 2B untereinander parallelgeschaltet angeordnet und ohne dazwischenliegende Schalter fest miteinander verdrahtet. Bei der vorliegenden Darstellung bilden die Kontaktelektroden K1 und die Kontaktelektroden K3 der Hall-Sensorelemente 1A, 2A, 1B, 2B die Stromeinprägungskontakte, wohingegen die Kontaktelektroden K2 und die Kontaktelektroden K4 der Hall-Sensorelemente 1A, 2A, 1B, 2B die Meßänschlüsse zur Erfassung einer Hall-Spannung liefern. Die Kontaktelektroden zum Zuführen eines Betriebsstroms und die Kontaktelektroden zur Erfassung einer Hall-Spannung sind in den einzelnen Hall-Sensorelement derart angeordnet, daß die Stromrichtung des eingeprägten Betriebsstroms jeweils senkrecht zu der Richtung der abgegriffenen Hall-Spannung ist.

Bei der vorliegenden Erfindung sind die Betriebsstromrichtungen in den beiden Hall-Sensorelementen jedes Paars jeweils um 90° zueinander gedreht. Die Stromrichtungen des zweiten Hall-Sensorelementepaars sind gegenüber den Stromrichtungen des ersten Hall-Sensorelementepaars um einen Winkel von 45° versetzt.

Bei der praktischen Ausführung der erfindungsgemäßen Hall-Sensoranordnung kann der Winkel, um den die Betriebsstromrichtungen in den beiden Hall-Sensorelementen jedes Paars zueinander gedreht sind, auch von dem Idealwert von 90° abweichen und in einem Bereich von z.B. 80° bis 100° liegen, wobei Winkel in diesem Bereich im Sinne der vorliegenden Erfindung als Winkel von im wesentlichen 90° angesehen werden. Dies gilt auch für den Winkel, um den die Stromrichtungen des zweiten Hall-Sensorelementepaars gegenüber den Stromrichtungen des ersten Hall-Sensorelementepaars versetzt sind, der beispielsweise in einem Bereich von 40° bis 50° gewählt werden kann und folglich im wesentlichen 45° beträgt. Es ist jedoch zu beachten, daß die erzielte Offset-Kompensation der Hall-Sensoranordnung bei einer steigenden Abweichung von den als optimal erachteten Idealwinkeln, die 90° bzw. 45° betragen, abnehmen kann.

Die untereinander fest verschalteten Kontaktelektroden K1, K2, K3, K4 der Hall-Sensorelemente 1A, 2A, 1B, 2B sind mit Schaltern S1, S2, S3, S4 verbunden, die jeweils zwischen vier Positionen, d.h. zwischen den Kontaktelektroden K1, K2, K3, K4, umgeschaltet werden können. Mit den Schaltern S1, S2, S3, S4 können die Kontaktelektroden K1, K2, K3, K4 in den einzelnen Meßphasen der Hall-Sensoranordnung als Versorgungsanschlüsse zum Zuführen eines Betriebsstroms I_{Betrieb} oder als Meßanschlüsse zur Erfassung einer Hall-Spannung U_{Hall} jeweils gemeinsam umgeschaltet werden.

Eine weitere Ausführungsform der erfindungsgemäßen Hall-Sensoranordnung (nicht explizit dargestellt) kann darin bestehen, daß mehr als zwei Paare von Hall-Sensorelementen verwendet werden. Dabei sind auch in diesem Fall die Stromrichtungen in den beiden Hall-Sensorelementen eines jeden Paars jeweils um im wesentlichen 90° zueinander gedreht. Auch hier müssen die beiden Hall-Sensorelemente eines Paars geometrisch gleich und bezüglich der Abmessungen der Hall-Sensorelemente eng benachbart sein, und können in der Gesamt-Sensoranordnung untereinander, nebeneinander oder in einer Diagonalen angeordnet sein. Die Stromrichtungen der mindestens zwei Hall-Sensorelementepaare sind jeweils untereinander um den Winkel von im wesentlichen 90°/n gedreht, wobei n die Anzahl der insgesamt verwendeten Hall-Sensorelement-Paare ist, wobei gilt n ≥ 2. Wenn beispielsweise drei Hall-Sensorelement-Paare verwendet werden, sind die Stromrichtungen der einzelnen Hall-Sensorelementepaare somit um eine Winkel von im wesentlichen 30° untereinander versetzt. Die Elementepaare der Sensoranordnung sind entweder nebeneinanderliegend oder in der Nebendiagonalen angeordnet, wobei sich die Hall-Sensorelemente paarweise möglichst nahe aneinander befinden.

Auch bei dieser Anordnung sind sowohl die Kontaktelektroden zum Zuführen eines Betriebsstroms I_{Setrieb} (oder einer Versorgungsspannung) als auch die Kontaktelektroden zum Abgreifen der Hall-Spannung U_{Hall} parallelgeschaltet angeordnet und ohne dazwischenliegende Schalter fest miteinander verdrahtet.

Durch die erfindungsgemäße Hall-Sensoranordnung mit zwei Paaren von Hall-Sensorelementen, siehe Fig. 1, oder auch mit mehreren Paaren von Hall-Sensorelementen entsteht aufgrund der geometrischen Plazierung der Hall-Sensorelemente bereits in jeder Meßphase ein vorkompensiertes Offset-Signal. So kann beispielsweise ein nachfolgender Verstärker mit einer höheren Verstärkung ausgeführt werden, weil derselbe nicht so schnell in eine Sättigung gehen kann. Der in den einzelnen Meßphasen noch enthaltene vorkompensierte Offset-Anteil der Sensorsignals wird durch die zyklische Umschaltung (z.B. Spinning-Current-Betrieb) der Betriebstromrichtungen und durch eine geeignete, vorzeichenrichtige und gewichtete Summierung oder Subtraktion der Signale der einzelnen Meßphasen während des Spinning-Current-Betriebs noch weiter reduziert, da die eingangs beschriebenen Offset-Anteile des Sensorsignals aufgrund von Inhomogenitäten oder von Verspannungen im Halbleitermaterial im wesentlichen beseitigt werden.

Dabei ist die angegebene geometrische Anordnung der Sensoren dahingehend von Vorteil, daß der Offset-Anteil eines einzelnen Hall-Sensorelements mit nur vier Anschlüssen kleiner ist als der eines Hall-Sensorelements mit einer anderen Geometrie, z.B. mit acht Kontaktelektroden. Daher verbleibt nach der zyklischen Umschaltung und Gewichtung ebenfalls ein kleinerer resultierender Offset-Anteil. Aufgrund der geometrischen Anordnung der Hall-Sensoranordnung und unter Verwendung des Spinning-Current-Verfahrens liefert die erfindungsgemäße Anordnung eine Hall-Spannung mit äußerst niedrigem Offset-Anteil, wobei die sich ergebende Hall-Spannung unabhängig von der beim Herstellungsprozeß der Hall-Sensoranordnung verwendeten Kristallrichtung bzw. von der Orientierung der Hall-Sensorelemente zu dieser Kristallrichtung ist.

Üblicherweise ist die Hall-Sensoranordnung als monolithisch integriertes Bauelement ausgeführt, wobei in dem Bauelement neben der Hall-Sensoranordnung auch eine Stromversorgung für die Hall-Sensorelemente als auch eine elektronische Auswerteschaltungen für die Hall-Spannung untergebracht sein können. Die Herstellung dieser Schaltungsanordnung wird im allgemeinen unter Verwendung von üblichen Silizium-Halbleitertechnologien mit bekannten Bipolar- oder MOS-Herstellungsprozessen durchgeführt. Durch die erfindungsgemäße Anordnung können die bekannten Nachteile, die Silizium als Hall-Sensorelementmaterial zugeordnet sind, d.h. eine geringe Hall-Empfindlichkeit und der große Einfluß des Piezo-Effekts, der zu dem Offset-Anteil des Sensorsignals führt, als auch der Einfluß von Inhomogenitäten im Halbleitermaterial im wesentlichen beseitigt werden.

Aufgrund der oben beschriebenen Parallelschaltung der jeweiligen Kontaktelektroden K1, K2, K3, K4 der einzelnen Hall-Sensorelemente sind bei der vorliegenden Hall-Sensoranordnung insgesamt nur vier Ausgangsverbindungen vorgesehen, die ohne größeren Schaltungsaufwand für die einzelnen Meßphasen einfach umgeschaltet und mit der nachfolgenden Auswerteelektronik verbunden werden können. Aufgrund dieser festen Verdrahtung ist es zusätzlich zu den oben beschriebenen Vorteilen hinsichtlich einer verbesserten Offset-Kompensation außerdem möglich, den erforderlichen Schaltungsaufwand gering zu halten, wodurch eine einfachere und damit kostengünstigere Herstellung dieser Hall-Sensoranordnungen gegenüber herkömmlichen Hall-Sensoren erreicht werden kann.

Im folgenden sind zur Verdeutlichung des erfindungsgemäßen Konzepts einige weitere unterschiedliche Anordnungsmöglichkeiten für die Hall-Sensorelemente gemäß der vorliegenden Erfindung beispielhaft dargestellt. Es ist zu beachten, daß die Hall-Sensorelemente eines Paares untereinander jeweils geometrisch gleich sein müssen, wobei sich aber die Hall-Sensorelemente unterschiedlicher Paare in der Geometrie unterscheiden können. Dadurch kann eine weitere Optimierung für den jeweiligen Anwendungsfall bzw. den Anwendungsbereich der Hall-Sensoranordnung durchgeführt werden.

In Fig. 2a sind die Hall-Sensorelementepaare 1A, 1B und 2A, 2B jeweils nebeneinander angeordnet, wobei die Hall-Sensorelemente beider Paare die gleiche geometrische Form aufweisen.

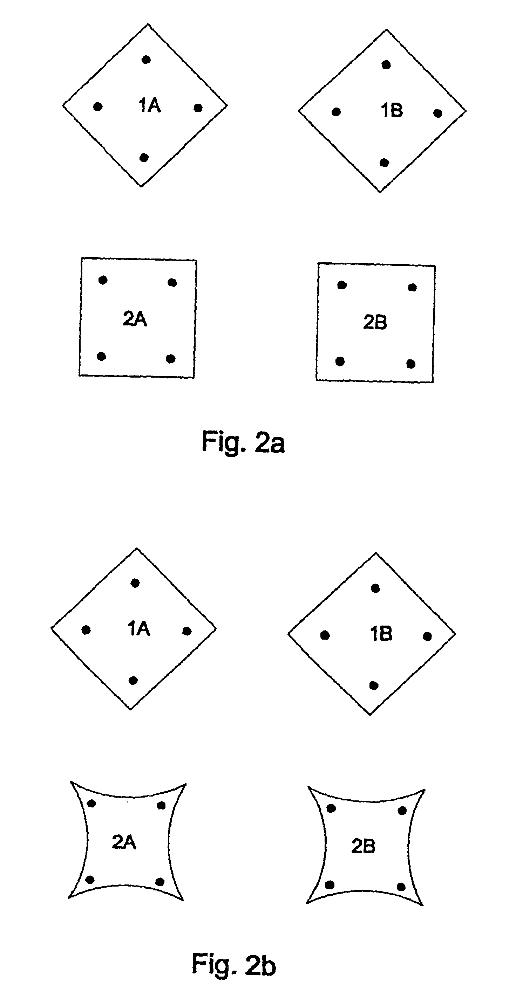

In Fig. 2b sind die Hall-Sensorelementepaare 1A, 1B und 2A, 2B jeweils nebeneinander angeordnet, wobei die Hall-Sensorelemente beider Paare eine unterschiedliche geometrische Form aufweisen.

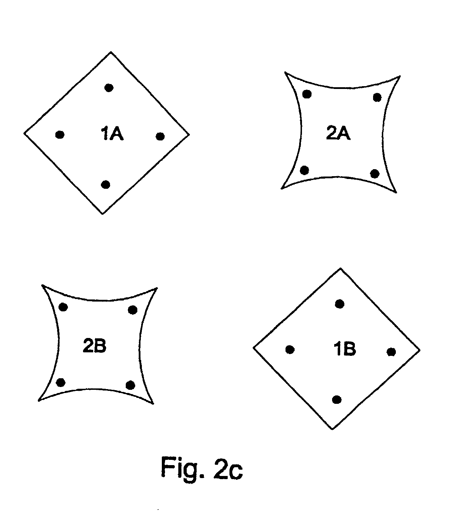

In Fig. 2c sind die Hall-Sensorelementepaare 1A, 1B und 2A, 2B jeweils diagonal angeordnet, wobei die Hall-Sensorelemente beider Paare eine unterschiedliche geometrische Form aufweisen.

Eine weitere vorteilhafte Möglichkeit für die geometrische Anordnung der einzelnen Hall-Sensorelementpaare besteht darin, die Hall-Sensorelemente so zu plazieren, daß bezüglich der Mittelpunkte der einzelnen Hall-Sensor-Elemente eine Kreissymmetrie vorliegt.

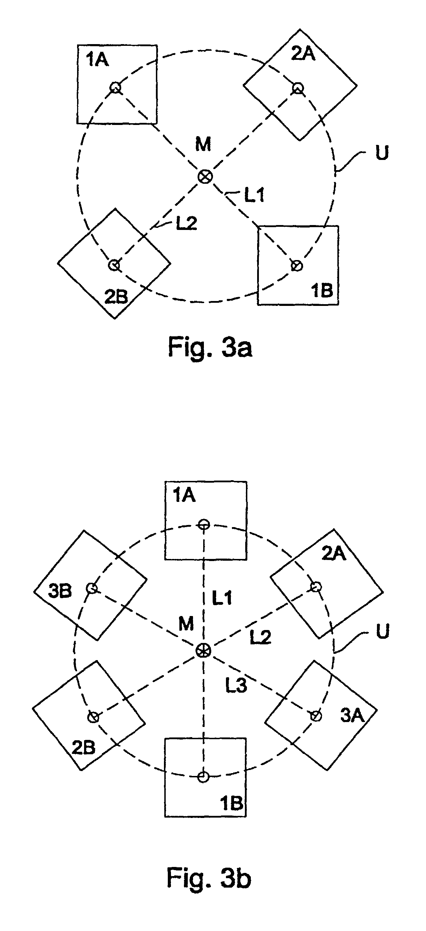

Eine beispielhafte geometrische Anordnung für zwei Paare von Hall-Sensorelementen 1A, 1B und 2A, 2B ist in Fig. 3a dargestellt. Verbindungslinien L1, L2 stellen jeweils die gedachte Verbindung zwischen den geometrischen Mittelpunkten der beiden Hall-Sensorelemente eines Paars dar. Die Verbindungslinien L1, L2 der beiden Paare von Hall-Sensorelementen 1A, 1B und 2A, 2B schneiden sich in einem Punkt M, der den geometrischen Mittelpunkt der gesamten Hall-Sensoranordnung darstellt. Bei dieser geometrischen Anordnung liegen die Mittelpunkte der einzelnen Hall-Sensorelemente 1A, 1B und 2A, 2B symmetrisch auf einer gedachten Kreislinie U, deren Mittelpunkt der Punkt M ist.

In Fig. 3b ist eine beispielhafte geometrische Anordnung für drei Paare von Hall-Sensorelementen dargestellt. Verbindungslinien L1, L2, L3 stellen jeweils die gedachte Verbindung zwischen den geometrischen Mittelpunkten der beiden Hall-Sensorelemente eines Paars dar. Die Verbindungslinien L1, L2, L3 der drei Paare von Hall-Sensorelementen 1A, 1B, 2A, 2B, 3A, 3B schneiden sich in einem Punkt M, der den geometrischen Mittelpunkt der gesamten Hall-Sensoranordnung darstellt. Bei dieser geometrischen Anordnung liegen die Mittelpunkte der einzelnen Hall-Sensorelemente 1A, 1B, 2A, 2B, 3A, 3B symmetrisch auf einer gedachten Kreislinie U, deren Mittelpunkt der Punkt M ist.

Alle im vorhergehenden, dargestellten Hall-Sensoranordnungen liefern die im vorhergehenden beschriebenen Vorteile bezüglich des verringerten Schaltungsaufwands als auch bezüglich der verbesserten Offset-Eigenschaften.

## Patentansprüche

1. Hall-Sensoranordnung mit folgenden Merkmalen:
einem ersten (1A, 1B) und wenigstens einem weiteren Paar (2A, 2B; 2A, 2B, 3A, 3B) von Hall-Sensorelementen,
wobei jedes Hall-Sensorelement (1A, 1B, 2A, 2B; 1A, 1B, 2A, 2B, 3A, 3B) vier Anschlüsse (K1, K2, K3, K4) aufweist, von denen zwei Anschlüsse (K1, K3) als Versorgungsanschlüsse zum Zuführen eines Betriebsstroms (I_{Betrieb}) und zwei Anschlüsse (K2, K4) als Meßanschlüsse zur Erfassung einer Hall-Spannung (U_{Hall}) vorgesehen sind,
wobei die Hall-Sensorelemente (1A, 1B, 2A, 2B; 1A, 1B, 2A, 2B, 3A, 3B) derart angeordnet sind, daß die Stromrichtungen des Betriebsstroms (I_{Betrieb}) in den zwei Hall-Sensorelementen jedes Paars um im wesentlichen 90° zueinander winkelmäßig versetzt sind,
wobei die Hall-Sensorelemente (2A, 2B; 2A, 2B, 3A, 3B) des wenigstens einen weiteren Paars derart angeordnet sind, daß ihre Stromrichtungen des Betriebsstroms (I_{Betrieb}) gegenüber den Stromrichtungen des Betriebsstroms (I_{Betrieb}) des ersten Paars (1A, 1B) von Hall-Sensorelementen um im wesentlichen 90°/n winkelmäßig versetzt sind, wobei n die Gesamtzahl der Paare von Hall-Sensorelementen ist,
wobei jeweilige erste der als Meßanschlüsse dienenden Anschlüsse (K2) der Hall-Sensorelemente und jeweilige zweite der als Meßanschlüsse dienenden Anschlüsse (K4) der Hall-Sensorelemente zur Erfassung der Hall-Spannung (U_{Hall}) miteinander verbunden sind,
wobei die Hall-Sensoranordnung ferner Schalter (S1, S2, S3, S4) aufweist, wobei die jeweiligen Anschlüsse (K1, K2, K3, K4) der Hall-Sensorelemente (1A, 1B, 2A, 2B) mit den Schaltern (S1, S2, S3, S4) verbunden sind, so daß die jeweiligen ersten und zweiten als die Versorgungsanschlüsse dienenden Anschlüsse (K1, K3) zum Zuführen eines Betriebsstroms (I_{Betrieb}) und die jeweiligen ersten und zweiten als die Meßanschlüsse dienenden Anschlüsse (K2, K4) zur Erfassung einer Hall-Spannung (U_{Hall}) von einer Messung zu einer folgenden Messung so umschaltbar sind, daß die Stromrichtungen des Betriebsstroms (I_{Betrieb}) in den Hall-Sensorelementen (1A, 1B, 2A, 2B) und die Hallspannungsabgriffrichtungen von einer Messung zu einer folgenden Messung um einen Winkel von im wesentlichen 90° drehbar sind,
wobei die Hall-Sensoranordnung ferner eine Steuereinrichtung aufweist, durch die die Schalter (S1, S2, S3, S4) so ansteuerbar sind, daß die Hall-Sensoranordnung im Spinning-Current-Betrieb zum Erzeugen eines Hall-Signals betrieben wird, wobei sich die Offsetspannungen der Hall-Sensorelemente bei einem Umlauf annähernd gegenseitig aufheben, so daß die echt magnetfeldabhängigen Anteile des Hall-Signals übrigbleiben,
**dadurch gekennzeichnet, daß**
jeweilige erste der als Versorgungsanschlüsse dienenden Anschlüsse (K1) jedes Hall-Sensorelements (1A, 1B, 2A, 2B; 1A, 1B, 2A, 2B, 3A, 3B) miteinander und einem ersten Anschluß einer gemeinsamen Spannungsguelle (U_{Betrieb}) verbunden sind, und jeweilige zweite der als Versorgungsanschlüsse dienenden Anschlüsse (K3) jedes Hall-Sensorelements miteinander und dem zweiten Anschluß der gemeinsamen Spannungsquelle (U_{Betrieb}) verbunden sind, so daß durch die gemeinsame Spannungsquelle (U_{Betrieb}) ein Betriebsstrom (I_{Betrieb}) für die Hall-Sensorelemente geliefert wird.

2. Hall-Sensoranordnung gemäß Anspruch 1, bei der die ersten der als Versorgungsanschlüsse dienenden Anschlüsse (K1) durch eine feste Verdrahtung elektrisch miteinander verbunden sind, die zweiten der als Versorgungsanschlüsse dienenden Anschlüsse (K3) durch eine feste Verdrahtung elektrisch miteinander verbunden sind, die ersten der als Meßanschlüsse dienenden Anschlüsse (K2) durch eine feste Verdrahtung elektrisch miteinander verbunden sind, und die zweiten der als Meßanschlüsse dienenden Anschlüsse (K4) durch eine feste Verdrahtung elektrisch miteinander verbunden sind.

3. Hall-Sensoranordnung gemäß Anspruch 1 oder 2, bei der die Hall-Sensorelemente eines Paars geometrisch gleich ausgeführt sind.

4. Hall-Sensoranordnung gemäß einem der Ansprüche 1 bis 3, bei der die Hall-Sensorelemente unterschiedlicher Paare geometrisch unterschiedlich ausgeführt sind.

## Claims

1. Hall sensor array comprising:
a first (1A, 1B) and at least one additional pair (2A, 2B; 2A, 2B, 3A, 3B) of Hall sensor elements,
wherein each Hall sensor element (1A, 1B, 2A, 2B; 1A, 1B, 2A, 2B, 3A, 3B) has four terminals (K1, K2, K3, K4), of which two terminals (K1, K3) act as power supply terminals for supplying an operating current (Iₒₚₑᵣₐₜᵢₒₙ) and two terminals (K2, K4) act as measurement terminals for measuring a Hall voltage (U_{Hall}),
wherein the Hall sensor elements (1A, 1B, 2A, 2B; 1A, 1B, 2A, 2B, 3A, 3B) are so arranged that the current directions of the operating current (Iₒₚₑᵣₐₜᵢₒₙ) in the two Hall sensor elements of each pair are offset at an angle of approximately 90° to one another,
wherein the Hall sensor elements (2A, 2B; 2A, 2B, 3A, 3B) of the additional pair(s) are so arranged that their current directions of the operating current (Iₒₚₑᵣₐₜᵢₒₙ) are offset at an angle of approx. 90°/n to the current directions of the operating current (Iₒₚₑᵣₐₜᵢₒₙ) of the first pair (1A, 1B) of Hall sensor elements, n being the total number of Hall sensor element pairs,
wherein respective first terminals of the measurement terminals (K2) of the Hall sensor elements and respective second terminals of the measurement terminals (K4) of the Hall sensor elements are connected together for measurement of the Hall voltage (U_{Hall}),
wherein the Hall sensor array also has switches (S1, S2, S3, S4) and wherein the respective terminals (K1, K2, K3, K4) of the Hall sensor elements (1A, 1B, 2A, 2B) are connected to the switches (S1, S2, S3, S4) so that the respective first and second supply terminals (K1, K3) for supplying an operating current (Iₒₚₑᵣₐₜᵢₒₙ) and the respective first and second measurement terminals (K2, K4) for measuring a Hall voltage (U_{Hall}) can be switched over from one measurement to a subsequent measurement in such a way that the current directions of the operating current (Iₒₚₑᵣₐₜᵢₒₙ) in the Hall sensor elements (1A, 1B, 2A, 2B) and the Hall voltage tapping directions can be rotated through approx. 90° from one measurement to a subsequent measurement,
wherein the Hall sensor array also has a control unit via which the switches (S1, S2, S3, S4) are controllable in such a way that the Hall sensor array is operable in spinning current operation for generating a Hall signal and wherein the offset voltages of the Hall sensor elements approximately cancel one another out in a revolution so that the Hall signal contributions which actually depend on the magnetic field remain,
**characterized in that**
respective first supply terminals (K1) of each Hall sensor element (1A, 1B, 2A, 2B; 1A, 1B, 2A, 2B, 3A, 3B) are connected together and to a first terminal of a common voltage source (Uₒₚₑᵣₐₜᵢₒₙ) and respective second supply terminals (K3) of each Hall sensor element are connected together and to the second terminal of the common voltage source (Uₒₚₑᵣₐₜᵢₒₙ) so that the common voltage source (Uₒₚₑᵣₐₜᵢₒₙ) supplies an operating current (Iₒₚₑᵣₐₜᵢₒₙ) for the Hall sensor elements.

2. Hall sensor array according to claim 1, wherein the first supply terminals (K1) are connected together electrically by being interwired, the second supply terminals (K3) are connected together electrically by being interwired, the first measurement terminals (K2) are connected together electrically by being interwired and the second measurement terminals (K4) are connected together electrically by being interwired.

3. Hall sensor array according to claim 1 or 2, wherein the Hall sensor elements of a pair are geometrically identical.

4. Hall sensor array according to one of the claims 1 to 3, wherein the Hall sensor elements of different pairs are geometrically different.

## Revendications

1. Dispositif de capteurs de hall ayant les caractéristiques suivantes :
une première paire (1A, 1B) d'éléments de capteurs de hall et au moins une autre paire (2A, 2B ; 2A, 2B, 3A, 3B) d'éléments de capteurs de hall,
chaque élément de capteurs de hall (1A, 1B, 2A, 2B ; 1A, 1B, 2A, 2B, 3A, 3B) présentant quatre raccordements (K1, K2, K3, K4), dont deux (K1, K3) sont prévus comme raccordements d'alimentation pour l'amenée d'un courant de service (I_{BETRIEB}) et deux (K2, K4) sont prévus comme raccordements de mesure pour la détection d'une tension de hall (U_{HALL}),
les éléments de capteurs de hall (1A, 1B, 2A, 2B; 1A, 1B, 2A, 2B, 3A, 3B) étant disposés de telle manière que les sens du courant de service (I_{BETRIEB}) sont principalement décalés en angle de 90° l'un par rapport à l'autre dans les deux éléments de capteurs de hall de chaque paire,
les éléments de capteurs de hall (2A, 2B ; 2A, 2B, 3A, 3B) de l'au moins une autre paire étant disposés de telle manière que leurs sens du courant de service (I_{BETRIEB}) sont principalement décalés en angle de 90°/n l'un par rapport à l'autre, par rapport aux sens du courant de service (I_{BETRIEB}) de la première paire (1A, 1B) d'éléments de capteurs de hall, n étant le nombre total de paires d'éléments de capteurs de hall,
les premiers des raccordements (K2) des éléments de capteurs de hall respectifs, servant de raccordements de mesure, et les seconds des raccordements (K4) des éléments de capteurs de hall respectifs, servant de raccordements de mesure, étant raccordés entre eux pour la détection de la tension de hall (U_{HALL}),
le dispositif de capteurs de hall présentant en outre des commutateurs (S1, S2, S3, S4), les raccordements respectifs (K1, K2, K3, K4) des éléments de capteurs de hall (1A, 1B, 2A, 2B) étant raccordés aux commutateurs (S1, S2, S3, S4) de sorte que les premiers et les seconds raccordements (K1, K3) respectifs servant de raccordements d'alimentation pour l'amenée d'un courant de service (I_{BETRIEB}) et les premiers et les seconds raccordements (K2, K4) respectifs servant de raccordements de mesure pour la détection d'une tension de hall (U_{HALL}) sont commutables d'une mesure à une mesure suivante, de telle manière que les sens du courant de service (I_{BETRIEB}) dans les éléments de capteurs de hall (1A, 1B, 2A, 2B) et que les sens de prise de la tension de hall sont pivotants, d'une mesure à une mesure suivante, d'un angle de principalement 90°,
le dispositif de capteurs de hall présentant en outre un dispositif de commande, avec lequel les commutateurs (S1, S2, S3, S4) sont commandables de telle manière que le dispositif de capteurs de hall fonctionne en régime de courant de rotation pour générer un signal de hall, les tensions offset des éléments de capteurs de hall se compensant approximativement mutuellement lors d'un cycle, de sorte que les fractions du signal de hall, vraiment dépendantes du champ magnétique, sont restantes,
**caractérisé en ce que**
les premiers des raccordements (K1) respectifs de chaque élément de capteurs de hall (1A, 1B, 2A, 2B ; 1A, 1B, 2A, 2B, 3A, 3B), servant de raccordements d'alimentation, sont raccordés entre eux et à un premier raccordement d'une source de tension commune (U_{BETRIEB}), et les seconds des raccordements (K3) respectifs de chaque élément de capteurs de hall, servant de raccordements d'alimentation, sont raccordés entre eux et au second raccordement de la source de tension commune (U_{BETRIEB}), de sorte qu'un courant de service (I_{BETRIEB}) est fourni pour les éléments de capteurs de hall par la source de tension commune (U_{BETRIEB}).

2. Dispositif de capteurs de hall selon la revendication 1, dans lequel les premiers des raccordements (K1) servant de raccordements d'alimentation sont raccordés électriquement entre eux par un câblage fixe, les seconds des raccordements (K3) servant de raccordements d'alimentation sont raccordés électriquement entre eux par un câblage fixe, les premiers des raccordements (K2) servant de raccordements de mesure sont raccordés électriquement entre eux par un câblage fixe, et les seconds des raccordements (K4) servant de raccordements de mesure sont raccordés électriquement entre eux par un câblage fixe.

3. Dispositif de capteurs de hall selon la revendication 1 ou 2, dans lequel les éléments de capteurs de hall d'une paire sont exécutés de manière géométrique identique.

4. Dispositif de capteurs de hall selon l'une quelconque des revendications 1 à 3, dans lequel les éléments de capteurs de hall de différentes paires sont exécutés de manière géométrique différente.
